(19) Europäisches Patentamt
European Patent Office
Office européen des brevets

(11) **EP 2 415 911 A1**

(12) **EUROPEAN PATENT APPLICATION**
published in accordance with Art. 153(4) EPC

(43) Date of publication:
**08.02.2012 Bulletin 2012/06**

(51) Int Cl.:
***C30B 29/36*** (2006.01)

(21) Application number: **10758779.2**

(22) Date of filing: **31.03.2010**

(86) International application number:
**PCT/JP2010/055820**

(87) International publication number:
**WO 2010/114008 (07.10.2010 Gazette 2010/40)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **03.04.2009 JP 2009090963**

(71) Applicant: **Bridgestone Corporation Tokyo 104-8340 (JP)**

(72) Inventors:
• **SEKI, Wataru**
  **Kodaira-shi, Tokyo 187-8531 (JP)**
• **KONDO, Daisuke**
  **Kodaira-shi, Tokyo 187-8531 (JP)**

(74) Representative: **Oxley, Robin John George**
  **Marks & Clerk LLP**
  **90 Long Acre**
  **London**
  **WC2E 9RA (GB)**

(54) **DEVICE FOR PRODUCING SINGLE CRYSTAL OF SILICON CARBIDE**

(57)    A apparatus (1) for manufacturing a silicon carbide single crystal comprises a graphite crucible (10) and configured so that the upper opening (11b) of a cylindrical crucible main body (11) has been blocked with a cover member (12), and a heating member comprising a single heating coil continuously wound around the outer periphery of the graphite crucible (10) and in which a sublimation material (50) is held on the bottom (11a) and a seed crystal (60) is attached to the inner surface (12a) of the crucible. The lower coil (31), which has wound around the bottom (11a) of the crucible main body (11), and the upper coil (32), which has wound around the cover member (12), have coil pitches (P1 and P3) which are smaller than the coil pitch (P2) of the central coil (33), which has wound around a center in the height-direction of the crucible main body (11).

FIG. 1

**Description**

**TECHNICAL FIELD**

The present invention relates to an apparatus of manufacturing a silicon carbide single crystal used when manufacturing a silicon carbide single crystal.

**BACKGROUND ART**

Conventionally, a sublimation recrystallization method has been disclosed as a silicon carbide single crystal manufacturing method for manufacturing a silicon carbide single crystal (hereinafter, referred to as a single crystal, where appropriate) from a seed crystal and a sublimation material, which include silicon carbide. A manufacturing apparatus used for the sublimation recrystallization method roughly includes a crucible and a heating member, and has a structure in which a powdery sublimation material is contained in a crucible main body, an upper opening of the crucible main body is blocked with a cover member, a seed crystal is attached to the inner surface of the crucible, and a heating coil (a heating member) is wound around the outer periphery of the crucible main body. Then, a current is allowed to flow through the heating coil to heat and sublimate the sublimation material, so that sublimated gas is generated. The sublimated gas is supplied to the seed crystal, so that a silicon carbide single crystal can be grown from the seed crystal (see Patent Document 1).

**PRIOR ART DOCUMENT**

**PATENT DOCUMENT**

Patent Document 1: JP-A-H05-178698

**SUMMARY OF THE INVENTION**

However, the heating coil disclosed in Patent Document 1 includes an upper coil for heating the seed crystal attached to the cover member, and a lower coil for heating the sublimation material contained in the bottom unit of the crucible main body, which are independent of each other. Therefore, it is necessary to separately adjust a value of a current flowing through the upper coil and a value of a current flowing through the lower coil. Thus, the structure of the heating member may be complicated, and it may be difficult to perform temperature control for adjusting a heating temperature by adjusting the amount of the current flowing through the upper coil and the lower coil.

Therefore, the present invention has been made to solve the above problems, an object of the present invention is to provide an apparatus of manufacturing a silicon carbide single crystal in which the structure of a heating member is simple and temperature control is easy.

The present invention for solving the above-mentioned problems has the following characteristics.

First, a first feature of the present invention is summarized as an apparatus (manufacturing apparatus 1) of manufacturing a silicon carbide single crystal, including a crucible (graphite crucible 10) and a heating member (heating member 30) formed of a single heating coil continuously wound around an outer periphery of the crucible, and to include a structure accommodating a sublimation material (sublimation material 50) on a bottom unit of the crucible and attaching a seed crystal (seed crystal 60) to an inner surface of the crucible facing the bottom unit, wherein the heating coil has a plurality of coil pitches (coil pitches P1, P3, for example).

As described above, a coil pitch is adjusted by changing the number of windings of the single heating coil, so that a tight winding portion and a loose winding portion are formed in one heating coil, resulting in the achievement of a simple structure and the improvement of power efficiency.

Another feature of the present invention is summarized that the heating member includes: a lower coil (lower coil 31) wound around the bottom unit; an upper coil (upper coil 32) wound around the inner surface of the crucible facing the bottom unit; and a center coil (center coil 33) wound around a center in a height direction of the crucible, wherein coil pitches (coil pitches P1, P3) of the upper coil and the lower coil are set to be smaller than a coil pitch (coil pitch P2) of the center coil.

Another feature of the present invention is summarized that the coil pitch P2 of the center coil is set in a range of 1.5 times to 20 times as long as the coil pitch P3 or P1 of the upper coil or the lower coil.

Another feature of the present invention is summarized that a height H from an upper end of the lower coil to a lower end of the upper coil satisfies $H < 1.2 \times h$, where the h denotes a height of the crucible.

According to the present invention, it is possible to achieve an apparatus of manufacturing a silicon carbide single crystal in which a structure is simple, power efficiency is high, and temperature control is easy.

## BRIEF DESCRIPTION OF THE DRAWINGS

[Fig. 1] Fig. 1 is a sectional view illustrating the outline of an apparatus of manufacturing a silicon carbide single crystal according to an embodiment of the present invention.
[Fig. 2] Fig. 2 is a perspective view illustrating a heating member according to an embodiment of the present invention.
[Fig. 3] Fig. 3 is a sectional view schematically illustrating a graphite crucible and a heating member according to an embodiment of the present invention.
[Fig. 4] Fig. 4 is a sectional view schematically illustrating a graphite crucible and a heating member in conventional example 1 according to an example.
[Fig. 5] Fig. 5 is a sectional view schematically illustrating a graphite crucible and a heating member in conventional example 2 according to an example.
[Fig. 6] Fig, 6 is a sectional view schematically illustrating a graphite crucible and a heating member in an example of the present invention according to an example.
[Fig. 7] Fig. 7 is a sectional view illustrating a graphite crucible and a heating coil for indicating the heating conditions of the graphite crucible and the heating coil according to an example.
[Fig. 8] Fig. 8 is a graph illustrating a change in the temperature inside a graphite crucible along an arrow A of Fig. 7.
[Fig. 9] Fig. 9 is a graph illustrating a measurement result inside a graphite crucible according to conventional example 1 and conventional example 2.
[Fig. 10] Fig. 10 is a graph illustrating a measurement result of a graphite crucible according to an example.

## MODES FOR CARRYING OUT THE INVENTION

Hereinafter, an embodiment of an apparatus of manufacturing a silicon carbide single crystal according to the present invention will be described with reference to the accompanying drawings. In the following drawings, the same or similar reference numerals are used to designate the same or similar parts. It will be appreciated that the drawings are schematically shown and the ratio and the like of each dimension are different from the real ones.
Therefore, detailed dimension and the like should be determined considering the following description. Of course, among the drawings, the dimensional relationship and the ratio are different.

<Apparatus of Manufacturing Silicon Carbide Single Crystal>

First, the structure of an apparatus of manufacturing a silicon carbide single crystal according to an embodiment of the present invention will be simply described.

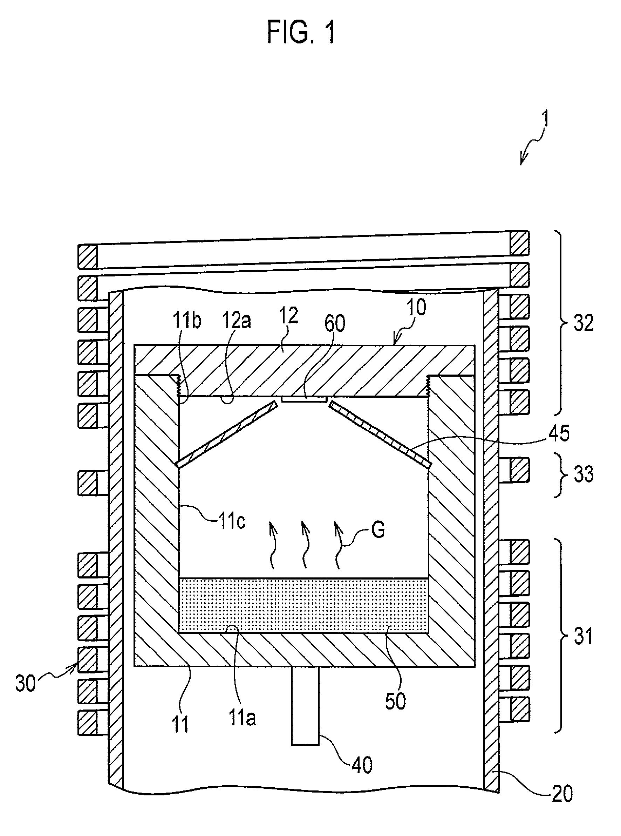

Fig. 1 is a sectional view illustrating the outline of an apparatus of manufacturing a silicon carbide single crystal according to the embodiment of the present invention.
As illustrated in Fig. 1, an apparatus of manufacturing a silicon carbide single crystal 1 includes a graphite crucible 10 constituting a crucible, and a heating member 30 formed of a single heating coil which is continuously wound around the outer periphery of the graphite crucible 10. Specifically, the apparatus of manufacturing a silicon carbide single crystal 1 includes the graphite crucible (crucible) 10, a quartz tube 20 covering the lateral side of the graphite crucible 10, and the heating member 30 arranged at the outer periphery of the quartz tube 20.
In the apparatus of manufacturing a silicon carbide single crystal 1, a sublimation material 50 is accommodated in the bottom unit 11a of the graphite crucible 10, and a seed crystal 60 is attached to a cover member 12 serving as the inner surface of the graphite crucible 10, which faces the bottom unit 11a.
Specifically, the graphite crucible 10 includes a crucible main body 11 and the cover member 12, and is moved by a support rod 40 to be fixed to the inside of the quartz tube 20. The sublimation material 50 (powder including silicon carbide) is accommodated in the bottom unit 11a of the crucible main body 11, The cover member 12 closes the upper opening 11b of the crucible main body 11 and is detachably coupled to the inner peripheral surface of the upper end unit of the crucible main body 11 through screw coupling. Further, the seed crystal 60 including silicon carbide adheres to the inner surface 12a of the crucible by adhesive. A guide member 45 is attached to the inner peripheral surface 11c of the crucible main body 11 to collect sublimated gas G and guide the sublimated gas G to the seed crystal 60.
The sublimation material 50 is a powdery sublimation material including silicon carbide, If the inside of the graphite crucible 10 reaches predetermined temperature and pressure conditions, the sublimation material 50 is sublimated to become the sublimated gas G. The sublimated gas G is supplied onto the seed crystal 60 and is recrystallized.

In this way, a silicon carbide signal crystal is formed and grown.

Further, the heating member 30 is a single heating coil in which a lower coil 31, an upper coil 32, and a center coil 33 are connected continuously to one another. The lower coil 31 is arranged at a position including a height position corresponding to at least the bottom unit 11a of the crucible main body 11. The upper coil 32 is arranged at a position including a height position corresponding to at least the cover member 12. The center coil 33 is arranged at the center in the height direction of the crucible main body 11. The height position of the graphite crucible 10 is changed by moving the support rod 40, so that the lower coil 31 can be arranged at a height position corresponding to the sublimation material 50 accommodated in the bottom unit 11a of the crucible main body 11, and the upper coil 32 can be arranged at a height position of the seed crystal 60 supported by the cover member 12. In the present embodiment, both the number of windings of the upper coil 32 and the number of windings of the lower coil 31 are set to six. However, the present invention is not limited thereto. For example, it is possible to variously set the number of windings according to the manufacturing conditions and the like of a seed crystal to be grown.

<Configuration of heating member>

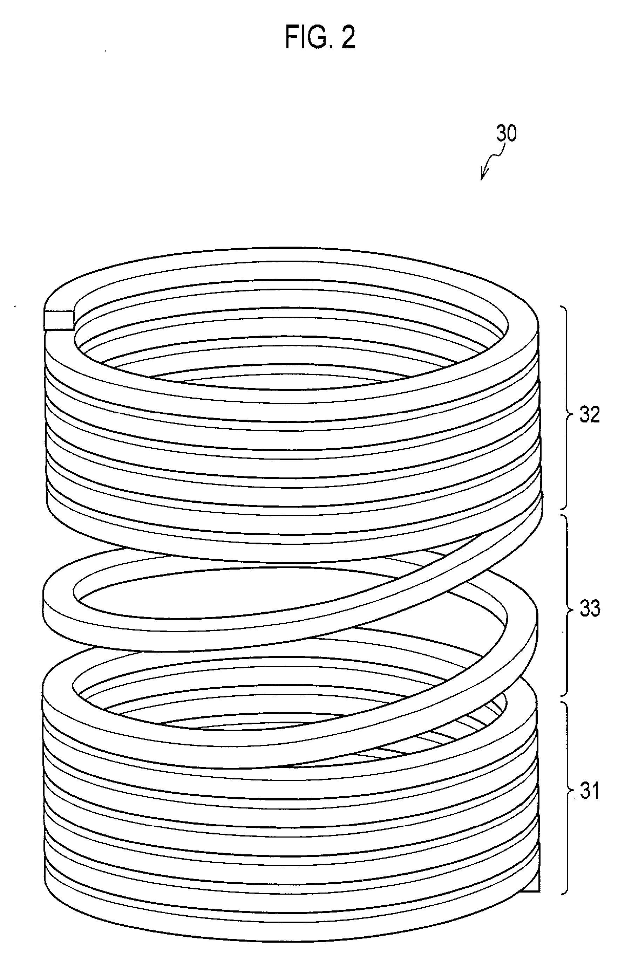

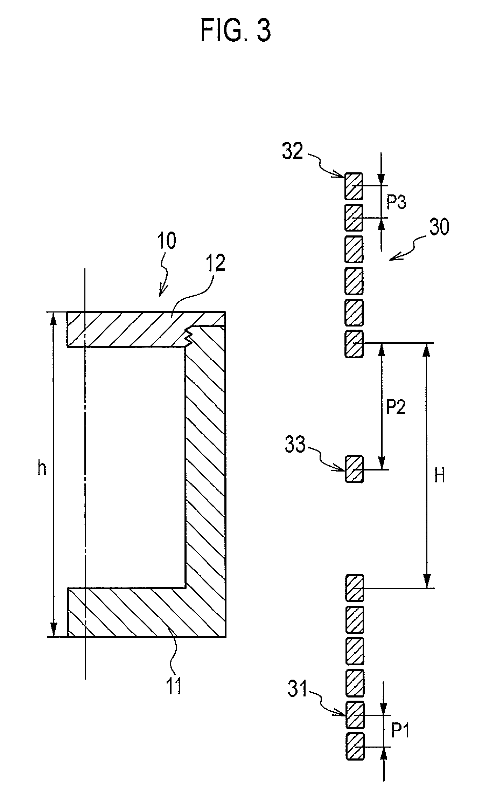

Fig. 2 is a perspective view illustrating the heating member according to the embodiment of the present invention and Fig. 3 is a sectional view schematically illustrating the crucible and the heating member according to the embodiment of the present invention.

As illustrated in Fig. 2, the heating member 30 according to the embodiment of the present invention is one continuous heating coil and has a spiral shape with approximately the same diameter. As illustrated in Figs. 2 and 3, in the heating member 30, the lower coil 31 arranged at the lower side, the upper coil 32 arranged at the upper side, and the center coil 33 arranged at the center in the height direction of the upper coil 32 and the lower coil 31 are integrally formed with one another.

As illustrated in Fig. 3, a coil pitch of the lower coil 31 is set to P1, a coil pitch of the center coil 33 is set to P2, and a coil pitch of the upper coil 32 is set to P3. Here, the heating coils constituting the heating member 30 are wound in a spiral shape and have vertical pitches between heating coils adjacent in the vertical direction. However, in the present embodiment, since the center coil 33 is wound once, the coil pitch P2 of the center coil 33 indicates a vertical pitch between the center coil 33 and a coil of a lower end unit of the upper coil 32. Therefore, when the center coil 33 is wound a plurality of times, the coil pitch P2 of the center coil 33 indicates a vertical pitch between heating coils adjacent in the vertical direction.

The pitches satisfy $P2 > P1$ and $P2 > P3$. Further, it is preferable to set the P2 to be a pitch in the range of 1.5 times to 20 times as long as the P1. That is, it is preferable to satisfy a condition of $1.5 \times P1 < P2 < 20 \times P1$ and $1.5 \times P3 < P2 < 20 \times P3$. Moreover, if H denotes the vertical height from the upper end of the lower coil 31 to the lower end of the upper coil 32 and h denotes the vertical height of the graphite crucible 10, it is preferable satisfy a relationship of $H < 1.2 \times h$.

<Silicon carbide single crystal manufacturing method>

Next, a silicon carbide single crystal manufacturing method according to the embodiment will be described in a step by step manner.

First, as illustrated in Fig. 1, the above-mentioned sublimation material 50 is prepared and accommodated in the bottom unit 11a of the crucible main body 11 of the graphite crucible 10. Next, the seed crystal 60 is held to the inner surface 12a of the crucible, and then the cover member 12 is coupled with the upper end of the crucible main body 11 through screw coupling.

Then, a current is allowed to flow through the lower coil 31, the center coil 33, and the upper coil 32 which constitute the heating member 30 while introducing argon gas into the quartz tube 20, thereby heating the graphite crucible 10. Since the sublimation material 50 is heated by energizing of the lower coil 31, the sublimation material 50 is sublimated to generate the sublimated gas G. The sublimated gas G is collected by the guide member 45 and supplied to the seed crystal 60.

Meanwhile, the seed crystal 60 is heated by energizing of the upper coil 32. However, the heating temperature of the sublimation material 50 is set to be higher than the heating temperature of the seed crystal 60 and the sublimated gas G is supplied to the seed crystal 60, resulting in the generation of a growing crystal.

In this way, single crystal ingots are formed. Among them, a single crystal ingot grown at a desired size is subject to peripheral grinding machining, and a slicing process for cutting a semiconductor wafer from the single crystal ingot, thereby completing a final semiconductor wafer.

<Operation and effect>

Hereinafter, the operation and effect according to the embodiment of the present invention will be described.

(1) The apparatus of manufacturing a silicon carbide single crystal 1 according to the embodiment of the present invention is an apparatus of manufacturing a silicon carbide single crystal which includes a graphite crucible 10, in which the upper opening 11b of the crucible main body 11 having a cylindrical shape is blocked by the cover member 12, and a heating member 30 formed of a single heating coil continuously wound around the outer periphery of the graphite crucible 10, and has a structure in which the sublimation material 50 is accommodated in the bottom unit 11a of the crucible main body 11 and the seed crystal 60 is attached to the inner surface 12a of the crucible. At least one of the coil pitches P1 and P3 of the lower coil 31, which is wound around the bottom unit 11a of the crucible main body 11, and the upper coil 32, which is wound around the cover member 12, is set to be smaller than the coil pitch P2 of the center coil 33 which is wound around the center in the height direction of the crucible main body 11.

As described above, a coil pitch is adjusted by changing the number of windings of the single heating coil, so that a tight winding portion and a loose winding portion are formed in one heating coil, resulting in the achievement of a simple structure and the improvement of power efficiency.

(2) Since the coil pitches P3 and P1 of the upper coil 32 and the lower coil 31 are set to be smaller than the coil pitch P2 of the center coil 33, it is possible to efficiently heat the seed crystal 60 and the sublimation material 50 at the same time.

(3) The coil pitch P2 of the center coil 33 is set to be 1.5 times to 20 times as long as the coil pitch P3 or P1 of the upper coil 32 or the lower coil 31. Consequently, the temperature of the center in the height direction of the crucible main body 11 can be reliably prevented from reducing more than necessary. The temperature of the center in the height direction of the crucible main body 11 is prevented from reducing more than necessary, so that sublimated gas can be reliably prevented from being recrystallized at the center thereof.

(4) The height H from the upper end of the lower coil 31 to the lower end of the upper coil 32 satisfies $H < 1.2 \times h$, wherein the h denotes the height of the graphite crucible 10. Consequently, the upper coil 32 and the lower coil 31 can reliably heat the parts of the crucible main body 11, other than the center thereof, in the height direction of the crucible main body 11,

Example

Hereinafter, in order to further clarify the effect of the present invention, the present invention will be further described in detail through the following examples.

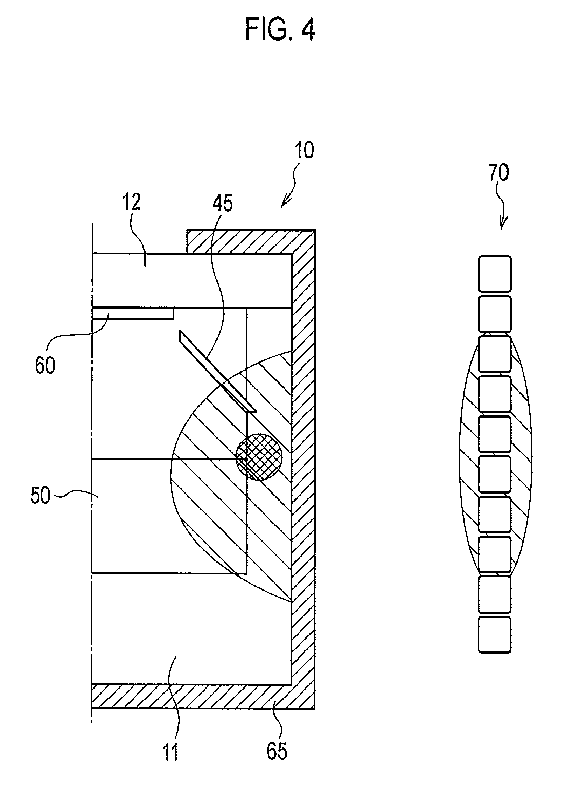

Figs. 4 to 6 are sectional views illustrating a graphite crucible and a heating coil in conventional examples 1 and 2 and the example of the present invention according to the example.

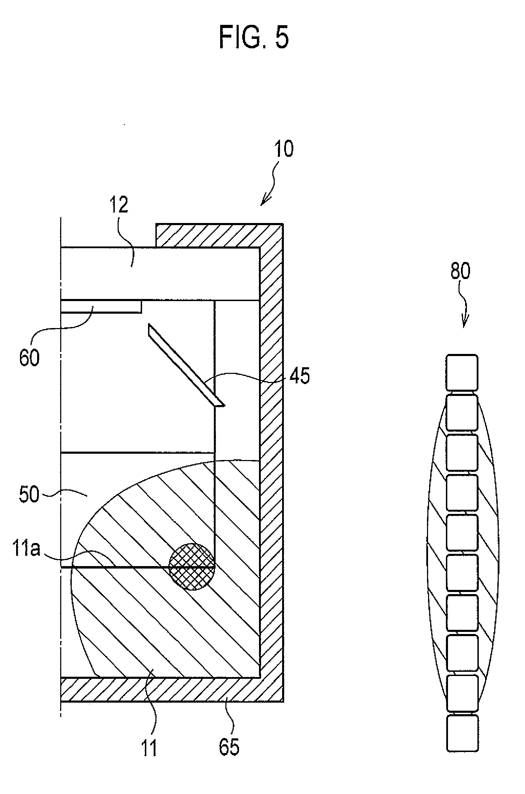

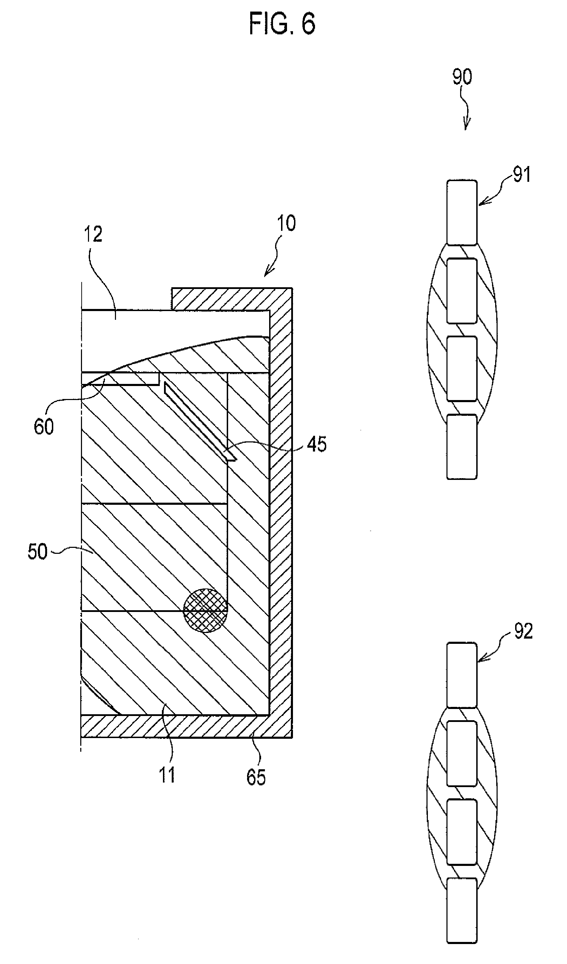

As illustrated in Fig. 6, the graphite crucible and the heating coil according to the example are substantially the same as the graphite crucible 10 and the heating coil 70 of Fig. 1, except that an adiabatic member 65 is further provided. Further, as illustrated in Figs. 4 and 5, the heating coils according to conventional examples 1 and 2 are different from the heating coil 30 of Fig. 1 and a heating coil 90 of Fig. 6 according to an example of the present invention because coil pitches of the heating coils are constant.

Since the graphite crucible and the heating coil according to the example are substantially the same as Fig. 1 except for the above-mentioned fact, detailed description thereof will not be repeated.

(Measurement conditions)

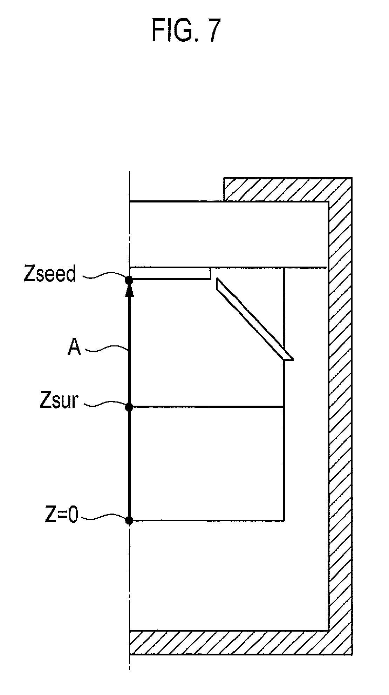

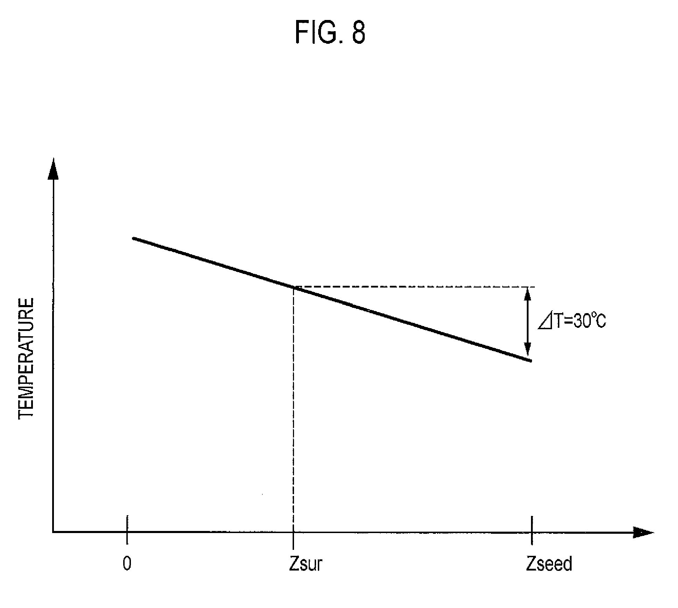

Fig. 7 is a sectional view illustrating a graphite crucible and a heating coil for indicating the heating conditions of the graphite crucible and the heating coil according to the example. Fig. 8 is a graph explaining the temperature conditions of the graphite crucible according to the example. Fig. 8 illustrates a change in the temperature inside the graphite crucible along an arrow A of Fig. 7. Fig. 8 illustrates the temperature conditions for growing a silicon carbide signal crystal with high quality. The temperature conditions described herein are to be appropriately set by a crystal quality and the like to be requited. Thus, it is not always necessary to satisfy the temperature conditions.

However, in order to acquire a silicon carbide signal crystal with high quality, it is necessary to inhibit a growth rate to be equal to or less than a constant value (e.g., 0.3 mm/h in the present example).

The growth rate depends on the temperature difference between the surface of a sublimation material and the surface of a seed crystal, that is, the temperature difference $\Delta T$ in Fig. 8. Therefore, in order to inhibit the growth rate to be equal to or less than the constant value, it is necessary to control the temperature difference $\Delta T$ to be equal to or less than a constant value (e.g., 30°C in the present example) (condition 1).

Further, in order to continue the growth of the silicon carbide signal crystal, it is necessary to uniformly lower the temperature from the bottom unit (z=0 in Fig. 7) of the sublimation material to the surface (z=Zsur in Fig. 7) of the sublimation material and the surface (z=Z seed in Fig. 7) of the seed crystal. That is, if the bottom unit of the sublimation material is set to z = 0, a Z axis is formed along the vertical direction of the graphite crucible, and a temperature in an arbitrary Z is defined as T(z), a condition for continuing the growth of the silicon carbide signal crystal is expressed by Equation 1 below (condition 2).

[Equation 1]

$$dT(z) / dz < 0 \quad (\text{where } 0 < z < Z \text{ seed}) \ldots \text{ Equation (1)}$$

Accordingly, since a material is always supplied to the surface of the seed crystal from the bottom unit of the sublimation material, the growth of the silicon carbide signal crystal can be continued.

(Measurement result)

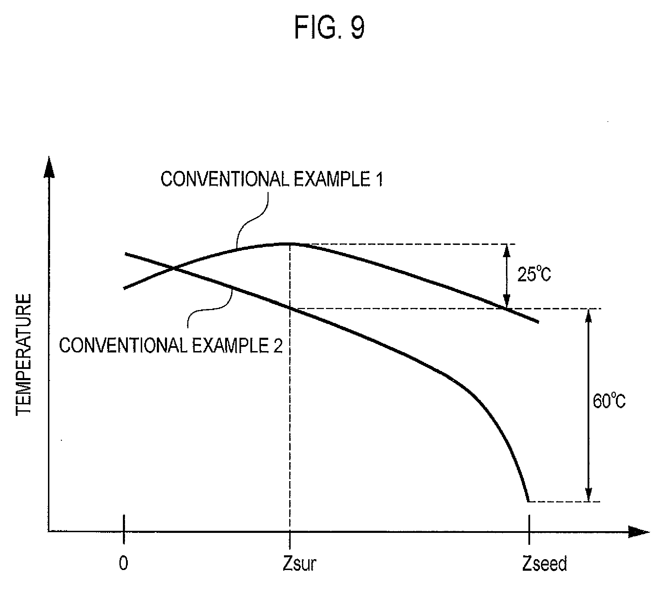

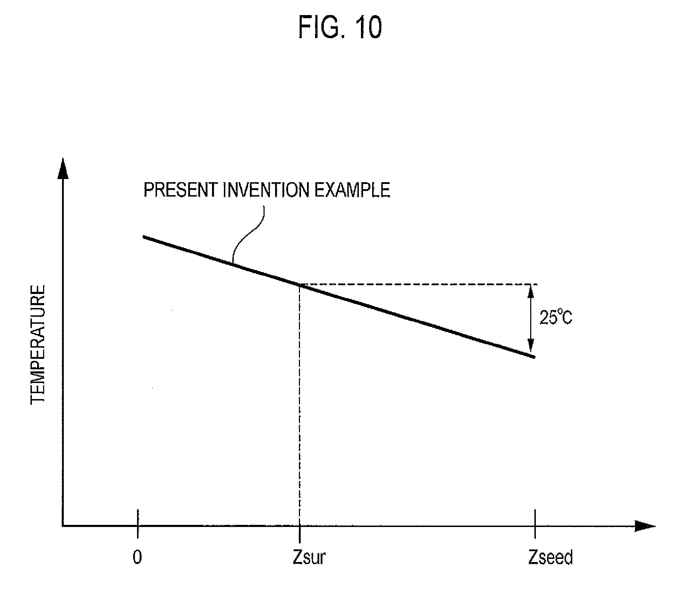

Fig. 9 is a graph illustrating a measurement result inside a graphite crucible according to the conventional example 1 and the conventional example 2. Fig. 10 is a graph illustrating a measurement result of a graphite crucible according to the example.

<Conventional example 1>

Fig. 4 illustrates the sections of the graphite crucible 10 and the heating coil 70 according to conventional example 1. The graphite crucible 10 had approximately the same structure as Fig. 1. That is, the sublimation material 50 was accommodated in the bottom unit of the crucible main body 11, the seed crystal 60 was attached to the inner surface 12a of the crucible, and the guide member 45 was provided around the seed crystal. Further, the heating coil 70 wound in a spiral shape around the outer periphery of the graphite crucible 10, which was spaced apart from the graphite crucible 10, was placed. The number of windings of the heating coil 70 was 10 and the heating coil 70 was wound at the same pitch. The center in the height direction of the heating coil 70 was made to correspond to the height of the upper surface of the sublimation material 50. In such a state, a current was allowed to flow through the heating coil 70 to heat the outer periphery of the graphite crucible 10.

As a consequence, as illustrated in Fig. 9, the temperature difference ΔT between the surface of the sublimation material and the surface of the seed crystal was 25°C. Thus, the condition 2 was not satisfied.

<Conventional example 2>

In the conventional example 2, an apparatus as approximately same as the conventional example 1 of Fig. 4 was used. However, the height position of a heating coil 80 was lowered than the conventional example 1, and the center in the height direction of the heating coil 80 was arranged corresponding to the height position of the bottom unit 11a of the crucible main body 11.

As a consequence, as illustrated in Fig. 9, the temperature difference ΔT between the surface of the sublimation material and the surface of the seed crystal was 60°C. Thus, the condition 1 was not satisfied.

<Example of present invention>

In the example of the present invention, a heating coil 90 included an upper coil 91 arranged at the upper side and a lower coil 92 arranged at the lower side, and the upper coil 91 and the lower coil 92 were integrally connected to each other using one single coil.

As a consequence, as illustrated in Fig. 10, the temperature difference ΔT between the surface of the sublimation material and the surface of the seed crystal was 25°C. Thus, the condition 2 was satisfied.

<Conclusion>

As described above, according to the present invention, since it was possible to simultaneously satisfy the condition 1 and the condition 2, it was found out that single crystal ingots with good quality could be produced.

It is noted that the entire contents of Japanese Patent Application No. 2009-90963 (filed on April 3, 2009) are hereby incorporated in the present specification by reference.

**INDUSTRIAL APPLICABILITY**

As described above, since the apparatus of manufacturing a silicon carbide single crystal according to the present invention can achieve an apparatus of manufacturing a silicon carbide single crystal in which a structure is simple, power efficiency is high, and temperature control is easy, the apparatus of manufacturing a silicon carbide single crystal is useful in the manufacturing field of a single crystal.

**EXPLANATION OF NUMERALS**

G ... Sublimated gas, 1 ... Apparatus of manufacturing a silicon carbide single crystal, 10 ... Graphite crucible (crucible), 11 ... Crucible main body, 11a ... Bottom unit, 11b ... Upper opening, 12 ... Cover member, 30 ... Heating member, 31 ... Lower coil (heating member), 32 ... Upper coil (heating member), 33 ... Center coil (Heating member), 50 ... Sublimation material, 60 ... Seed crystal

**Claims**

1. An apparatus of manufacturing a silicon carbide single crystal, including a crucible and a heating member formed of a single heating coil continuously wound around an outer periphery of the crucible, and to include a structure accommodating a sublimation material on a bottom unit of the crucible and attaching a seed crystal to an inner surface of the crucible facing the bottom unit, wherein
the heating coil has a plurality of coil pitches.

2. The apparatus of manufacturing a silicon carbide single crystal according to claim 1, wherein the heating member comprises:

   a lower coil wound around the bottom unit;
   an upper coil wound around the inner surface of the crucible facing the bottom unit; and
   a center coil wound around a center in a height direction of the crucible, wherein
   coil pitches of the upper coil and the lower coil are set to be smaller than a coil pitch of the center coil.

3. The apparatus of manufacturing a silicon carbide single crystal according to claim 1 or 2, wherein
the coil pitch P2 of the center coil is set in a range of 1.5 times to 20 times as long as the coil pitch P3 or P1 of the upper coil or the lower coil.

4. The apparatus of manufacturing a silicon carbide single crystal according to any one of claims 1 to 3, wherein
a height H from an upper end of the lower coil to a lower end of the upper coil satisfies $H < 1.2 \times h$, where the h denotes a height of the crucible.

# FIG. 1

# FIG. 2

# FIG. 3

# FIG. 4

# FIG. 5

# FIG. 6

# FIG. 7

# FIG. 8

# FIG. 9

FIG. 10

## INTERNATIONAL SEARCH REPORT

| | International application No. |
|---|---|
| | PCT/JP2010/055820 |

**A. CLASSIFICATION OF SUBJECT MATTER**
*C30B29/36(2006.01)i*

According to International Patent Classification (IPC) or to both national classification and IPC

**B. FIELDS SEARCHED**

Minimum documentation searched (classification system followed by classification symbols)
C30B29/36

Documentation searched other than minimum documentation to the extent that such documents are included in the fields searched
Jitsuyo Shinan Koho          1922-1996   Jitsuyo Shinan Toroku Koho   1996-2010
Kokai Jitsuyo Shinan Koho    1971-2010   Toroku Jitsuyo Shinan Koho   1994-2010

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 04-065400 A (Sanyo Electric Co., Ltd.),<br>02 March 1992 (02.03.1992),<br>claims; page 2, upper left column, lines 10 to 15<br>(Family: none) | 1<br>1-4 |
| Y | JP 2006-290685 A (Bridgestone Corp.),<br>26 October 2006 (26.10.2006),<br>paragraph [0025]; fig. 1<br>(Family: none) | 1-4 |
| Y | JP 2006-131433 A (Sumitomo Metal Industries, Ltd.),<br>25 May 2006 (25.05.2006),<br>paragraph [0027]<br>(Family: none) | 1-4 |

☒ Further documents are listed in the continuation of Box C.      ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>23 June, 2010 (23.06.10) | Date of mailing of the international search report<br>06 July, 2010 (06.07.10) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/055820

C (Continuation).  DOCUMENTS CONSIDERED TO BE RELEVANT

| Category* | Citation of document, with indication, where appropriate, of the relevant passages | Relevant to claim No. |
|---|---|---|
| A | JP 11-209198 A  (Sumitomo Electric Industries, Ltd.),<br>03 August 1999 (03.08.1999),<br>fig. 1, symbol 17<br>& US 6193797 B1          & US 2001/0000864 A1<br>& EP 933450 A1           & DE 69901269 D<br>& CN 1225953 A | 1-4 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H05178698 A

- JP 2009090963 A